Europäisches Patentamt

European Patent Office

Office européen des brevets

(11) Publication number: 0 398 638
A2

# EUROPEAN PATENT APPLICATION

(21) Application number: 90305211.6

(22) Date of filing: 15.05.90

(51) Int. Cl.5: H03M 1/66

(30) Priority: 16.05.89 JP 121996/89

(43) Date of publication of application:
22.11.90 Bulletin 90/47

(84) Designated Contracting States:
DE FR GB

(71) Applicant: PIONEER ELECTRONIC
CORPORATION
No. 4-1, Meguro 1-chome
Meguro-ku Tokyo-to(JP)

(72) Inventor: Yoshio, Junichi, c/o Pioneer
Electronic Corp.
Tokorozawa Works, No. 2610 Hanazono
4-chome
Tokorozawa-shi Saitama-ken(JP)
Inventor: Suzuki, Masami, c/o Pioneer
Electronic Corp.
Tokorozawa Works, No. 2610 Hanazono
4-chome
Tokorozawa-shi Saitama-ken(JP)
Inventor: Tsuchida, Masami, c/o Pioneer
Electronic Corp.
Tokorozawa Works, No. 2610 Hanazono
4-chome
Tokorozawa-shi Saitama-ken(JP)
Inventor: Iwai, Kiyoshi, c/o Pioneer Electronic
Corp.
Tokorozawa Works, No. 2610 Hanazono
4-chome
Tokorozawa-shi Saitama-ken(JP)

(74) Representative: Brunner, Michael John et al
GILL JENNINGS & EVERY 53-64 Chancery
Lane
London WC2A 1HN(GB)

(54) Digital-to-analog converter device.

(57) A digital-to-analog converter device includes a digital filter (6) for producing a digital signal (Vd) which is applied to an attenuator (16). The attenuator (16) attenuates the digital signal by a level ($L_{DTH}$) corresponding to the level of a dither signal (Vg, Vℓ) to be added to the digital signal, and produces an attenuated digital output signal (Vh) having an attenuated level ($L_{ATT}$). The dither signal (Vg, Vℓ), which is generated by a dither generator (14, 17), is added to the attenuated digital signal (Vh) by an adder (11). A sum signal (Vi) from the adder (11) is converted by a D/A converter (12) into an analog signal (Vj), from which the dither signal (Vg, Vℓ) is removed by a low-pass filter (8).

FIG. 1

# DIGITAL-TO-ANALOG CONVERTER DEVICE

The present invention relates to a digital-to-analog (D/A) converter device, and more particularly to a D/A converter device for use in an information reproducing device for reproducing music information recorded on optical disks such as compact disks (CDs).

Digital audio devices such as CD players incorporate D/A converters for converting digital signals recorded on recording mediums such as CDs into analog signals for audio signal reproduction.

Generally, D/A converters do not have ideal conversion characteristics. Most D/A converters produce conversion errors, and generated analog signals contain quantization noise which is produced during D/A conversion. These noise components are responsible for distortion of reproduced signals.

One known solution is to add a dither signal to a digital signal. A dither circuit adds, as a dither signal, white noise having a suitable amplitude level to a digital signal to be applied to the input terminal of a D/A converter, and subtracts the dither signal from an analog signal which is produced from the output terminal of the D/A converter.

Adding the dither signal to the digital signal, however, causes the digital signal to produce an overflow by the level of the dither signal in excess of the headroom of the reproducing system if the digital signal to be reproduced is of an overflow level. As a result, the dither signal cannot be removed from the analog signal when the dither signal is to be subtracted from the analog signal. The remaining dither signal distorts the reproduced signal.

Various attempts have been made to improve the above deficiency. According to one proposal, a dither circuit reduces a dither level depending on the level of an input signal (see Japanesse Laid-Open Utility Model Publication No. 62-112221). However, since the dither level to be added is not constant, the dither signal cannot be fully effective in noise removal, and hence the waveform of the reproduced signal cannot be fully prevented from being distorted.

Another effort is directed to a digital dither adding circuit which stops adding a dither signal when an overflow occurs (see Japanese Utility Model Publication No. 61-20709). However, the digital dither adding circuit cannot fully remove waveform distortions produced while the addition of the dither signal is being stopped. As the reproduced signal may contain waveform discontinuities, good reproduction characteristics may not be obtained.

According to still another proposal, a D/A converter device includes a limiter for limiting a reproduced signal in a signal range which reaches an overflow level (see Japanese Laid-Open Patent Publications Nos. 64-73825 and 64-73826). Since the reproduced signal is limited, the waveform thereof becomes different from waveform of an original signal. Therefore, this proposed D/A converter device has a high-fidelity problem.

It is an object of the present invention to provide a digital-to-analog converter device which has a dither generator of a simple arrangement which is capable of suppressing an overflow without producing waveform distortions.

According to the present invention, there is provided a digital-to-analog converter device comprising a digital filter for removing digital noise from a digital signal which is sampled at a predetermined sampling frequency, a dither generator for generating a dither signal, an adder for adding the dither signal to a digital signal from the digital filter, a D/A converter for converting an output signal from the adder into an analog signal, and an attenuator for attenuating the digital signal from the digital filter to a level which is lower than an overflow level by the level of the dither signal, and producing an attenuated output signal.

The digital signal applied to the adder is attenuated by the attenuator to a signal level which is lower than the overflow level by the dither level. Therefore, even when the dither signal from the dither generator is added to the attenuated digital signal, a reproduced signal produced by the digital-to-analog converter device is not subjected to an overflow. Since the attenuator lowers the level of the applied signal in its entirety, rather than locally, the attenuated signal does not have waveform distortions and its dynamic range is not impaired.

The above and other objects, features and advantages of the present invention will become more apparent from the following description when taken in conjunction with the accompanying drawings in which preferred embodiments of the present invention are shown by way of illustrative examples.

FIG. 1 is a block diagram of a CD player incorporating the principles of the present invention;

FIG. 2 is a block diagram of a signal processing LSI circuit;

FIG. 3 is a block diagram of a conventional D/A converter device;

FIG. 4 is a block diagram of a D/A converter device according to a first embodiment of the present invention;

FIG. 5 is a diagram illustrative of a digital signal overflow;

FIG. 6 is a diagram showing the manner in which a digital signal is attenuated according to the present invention;

FIG. 7 is a block diagram of a D/A converter device according to a second embodiment of the present invention;

FIG. 8 is diagram illustrating a frequency spectrum in an oversampling process; and

FIG. 9 is a block diagram of a D/A converter device according to a third embodiment of the present invention.

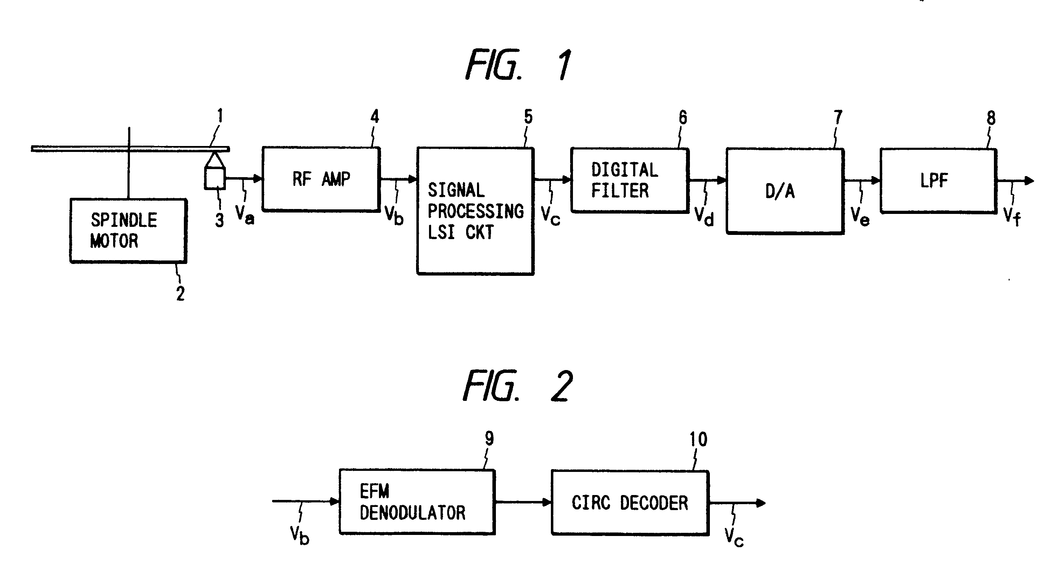

A CD player incorporating the principles of the present invention is shown in FIG. 1. FIG. 1 shows an audio signal reproducing system of the CD player.

A compact disk or CD 1 has a recording surface on which a signal track containing recording information is formed, the signal track being spirally formed progressively from an inner circumferential edge toward an outer circumferential edge of the CD 1. The signal track is in the form of a series of signal pits recessed into the recording surface and representing the recorded information. When the recorded information is read, a spindle motor 2 is energized to rotate its shaft at a predetermined speed. The shaft of the spindle motor 2 is connected to a turntable (not shown) on which the CD 1 is supported. Therefore, when the spindle motor 2 is energized, the CD 1 on the turntable is also rotated. Which the CD is rotating, a reading laser beam is generated by an optical pickup 3 and applied to the signal track. The applied laser beam is reflected by the signal track, and is selectively returned, i.e., returned or not returned, to the optical pickup 3 depending on whether it is reflected by the signal pits or not. The reflected laser beam which has returned to the optical pickup 3 is converted thereby into an electric signal Va which is referred to as an RF (Radio-Frequency) signal. The RF signal Va contains a high-frequency component which is lower in amplitude than the low-frequency component thereof and hence which will not be advantageously converted into a binary signal. The RF signal Va is shaped in waveform and converted into a binary digital signal Vb by an RF amplifier 4. The digital signal Vb thus produced is then applied to a signal processing LSI (Large-Scale-Integration) circuit 5 by which the digital signal Vb is processed.

The digital signal Vb may be processed in various ways by the signal processing LSI circuit 5. One major signal processing arrangement of the signal processing LSI circuit 5 is shown in FIG. 2, and includes an EFM (Eight to Fourteen Modulation) demodulator circuit 9, and an error correcting circuit 10. The EFM allows the laser beam to track the signal pits correctly for clearly determining whether pulses are present or not. The error correction is effected by adding an error correcting code related to the signal pulses, e.g., CIRC (Cross Interleave Reed-Solomon Code), to the recorded signal. A digital signal Vc, which is processed by the signal processing LSI circuit 5, is then sent to a digital filter 6.

The digital filter 6 is employed to simplify the arrangement of a low-pass filter at the output stage of the CD player. The digital filter 6 may be a nonrecursive (FIR or Finite-Impulse-Response) digital filter having linear phase characteristics, for example. A digital signal Vd, which is produced by the digital filter 6, is then applied to a D/A converter device 7.

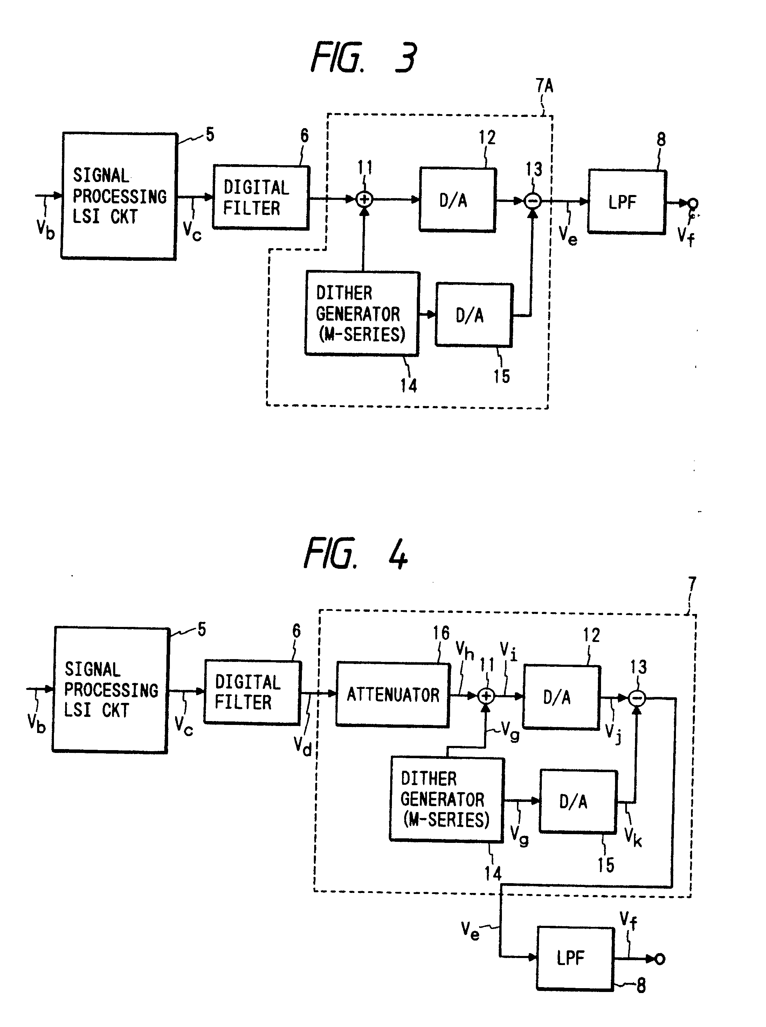

For a better understanding of the D/A converter device 7, a conventional D/A converter device 7A (FIG. 3) which employs a dither generator will first be described below with reference to FIG. 3. A digital signal read from the CD 1 is processed by the signal processing LSI circuit 5, and then the sampling rate fs of the digital signal is converted by the digital filter 6 into a rate N times higher. Then, the digital signal is converted into an analog signal by a D/A converter 12. Between the digital filter 6 and the D/A converter 12, there is connected an adder 11 which adds a random M-series dither signal (noise) from a dither generator 14 to the digital signal for converting the quantization noise into white noise and suppressing a conversion error. Since it is necessary to remove the added dither signal subsequently, a subtractor 13 is connected to the output of the D/A converter 12, and the dither signal from the dither generator 14 is converted by another D/A converter 15 into an analog signal, which is used to subtract (or remove) the dither signal from the analog signal produced by the D/A converter 12. The analog signal Ve, from which the dither signal has been removed, is transmitted as an output signal through an analog low-pass filter 8. The analog low-pass filter 8 cuts off a signal component having an oversampling frequency $N \cdot fs$ which is produced by the oversampling of N times higher.

First Embodiment

The D/A converter 7 according to the present invention is shown in detail in FIG. 4. The D/A converter 7 comprises an attenuator 16 for attenuating the digital signal Vd from the digital filter 6 by a predetermined level, a dither generator 14 for generating a digital dither signal Vg, an adder 11 for adding the digital dither signal Vg to a digital signal Vh from the attenuator 16, a D/A converter 12 for converting a sum digital signal Vi from the adder 11 into an analog signal Vj, a D/A converter 15 for converting the digital dither signal Vg into an analog dither signal Vk, and a subtractor 13 for subtracting the analog dither signal Vk from the analog signal Vj.

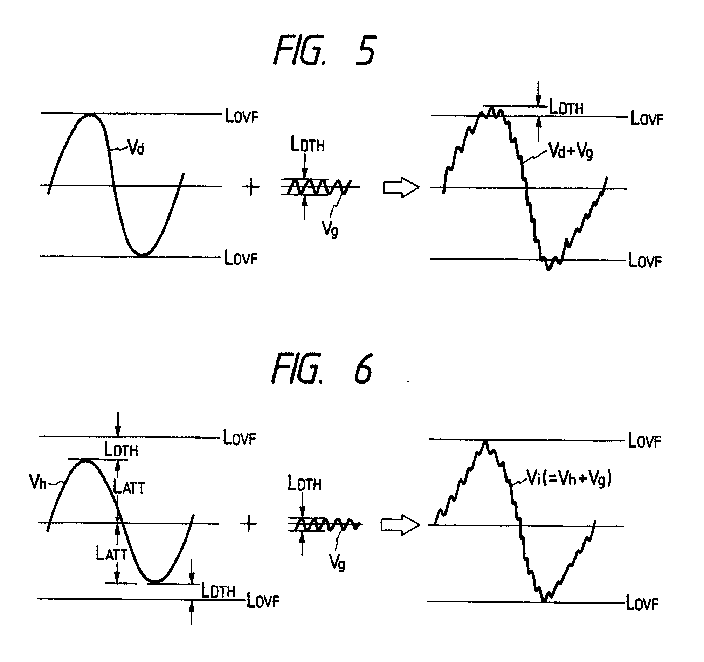

As shown in FIG. 6, the attenuator 16 serves to reduce the level of the digital signal Vd from the digital filter 6 to an attenuated level $L_{ATT}$ which is lower by a dither level $L_{DTH}$. As a result, when the digital dither signal Vg from the dither generator 14 is added to the signal Vh by the adder 11, no overflow is caused from the signal which is applied to the D/A converter 12. Since the digital signal Vd is attenuated in its entirety by the attenuator 16, but not locally clipped to remove any over flow level only, the signal waveform is not distored by the attenuator 16. The attenuator 16 may comprise, for example, a multiplier for multiplying the digital signal Vd by suitable coefficient data (< 1). Such a multiplier is known as a digital attenuator, and can adjust the signal to a desired attenuated level by employing suitable coefficient data corresponding to the level by which the signal is to be attenuated.

A specific example of the attenuated level $L_{ATT}$ will be described below. A digital signal Vd recorded in a CD or the like in a full scale ( 0 dB) is expressed according to the two's complement representation as follows:

Positive:

MSB                         LSB

0   1   1   1   •   •   •   1

Negative:

MSB                         LSB

1   0   0   0   •   •   •   0

When a dither signal Vg having a level $L_{DTH}$ is added to the digital signal Vd, the sum digital signal produces an overflow as shown in FIG. 5. The dither signal level $L_{DTH}$ is a few bits lower than the level $L_{OVF}$ in the full scale. For example, if the full scale of the digital signal Vd is of 16 bits, and full scale of the dither signal Vg is of 12 bits, then the dither signal Vg has a level of - 4 bits which is a low level of - 24 dB. When the digital dither signal Vg of this level is added to the level $L_{OVF}$ of the full scale, if the full scale is expressed by "1", then the level of the digital signal Vd + Vg becomes about "1.063", resulting in an overflow. In order to reduce the level of the digital signal Vd to "1", the digital signal Vd needs to be attenuated by about - 0.5 dB. The signal Vh is produced by the attenuator 16 after the digital signal Vd is attenuated by - 0.5 dB.

The necessary attenuated level $L_{ATT}$ is determined from the dither level $L_{DTH}$ to be added, and the attenuator 16 is arranged to reach the attenuated level $L_{ATT}$. In this manner, any overflow is prevented, and the dither signal is effective to remove errors and noise from the digital signal.

The dither generator 14 generates a digital dither signal Vg composed of a predetermined number of bits. When an original signal is quantized, if the level of the original signal is low, the quantized digital signal has a high frequency component correlated to the original signal. As a result, the digital signal contains noise called granular noise. The granular noise will be highly offensive to the ear as compared with white noise. The dither signal is employed to convert the granular noise into white noise. The dither level LDTH of the digital dither signal Vg corresponds to white noise having a small amplitude equal to the width or interval of quantizing steps. However, a dither signal of a large amplitude may also be employed. The dither generator 14 includes an amplifier to amplify thermal noise (white noise) which is generated when a zener diode or the like is energized. The amplified noise is used as an output dither signal of the dither generator 14.

The adder 11 comprises a digital adder for adding the digital signal Vh and the digital dither signal Vg.

The D/A converter 12 may be of the R-2R ladder resistance type, the integration type, the weighting resistance type, or the like.

The D/A converter 15 may also be of any of the various types as the D/A converter 12. The D/A converter 15 serves to convert the digital dither signal Vg from the dither generator 14 into the analog dither signal Vk.

The subtractor 13 comprises a summing operational unit in the form of an operational amplifier or the like, and subtracts the analog dither signal Vk from the analog signal Vj which comes from the D/A converter 14, thereby producing an analog signal Ve.

The low-pass filter 8 comprises an active filter composed of an operational amplifier, a capacitor, and a resister. The low-pass filter 8 has a cutoff frequency which is higher than the frequency range, extending from 0 to 20 kHz, of the original signal. The attenuation curve of the low-pass filter 8 depends on the oversampling frequency of the digital filter 6, such that the higher the oversampling frequency, the less steep the attenuation curve. The low-pass filter 8 passes only the frequencies of the analog signal Ve in the passband ranging from 0 to 20 kHz, and removes higher frequencies. As a result, the low-pass filter 8 produces a reproduced audio signal Vf in that frequency range, with foldover frequency components (the high-frequency components of 174.4 kHz ± 20 kHz in the above example) removed therefrom.

The reproduced audio signal Vf is amplified by a stereo amplifier or the like, and the amplified audio signal is converted by speakers into an acoustic signal which reached the ears of the listener.

Second Embodiment

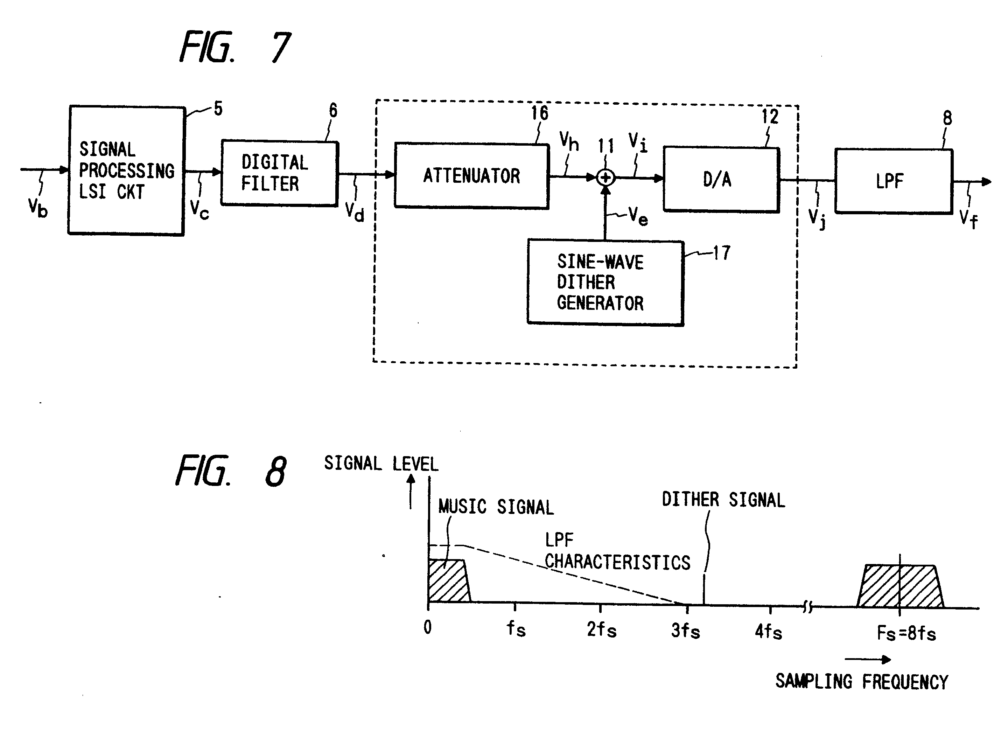

FIG. 7 shows a D/A converter device according to a second embodiment of the present invention.

In the second embodiment, a sine-wave dither generator 17 for adding a digital dither signal Ve to a digital signal Vh is employed, and the D/A converter 15 shown in FIG. 4 is dispensed with.

Where the D/A converter 15 is used in addition to the D/A converter 12 as is the case with the first embodiment shown in FIG. 4, the D/A converter device is large in size, complex in structure, and expensive to manufacture. If the D/A converters 12, 15 are poor in accuracy, e.g., have different conversion characteristics, the added dither signal cannot completely be removed by the subtractor 13, and the reproduced signal may contain noise. The D/A converter device of the second embodiment is designed to eliminate this drawback.

In FIG. 7, a digital signal Vc from the signal processing LSI circuit 5 is applied to the digital filter 6. The digital filter 6 shifts foldover noise and quantization noise contained in the digital signal out of the audible frequency range through the oversampling using the N-times-higher frequency, and produces an output signal. FIG. 8 shows a frequency spectrum of the digital signal subjected to the oversampling. In FIG. 8, the oversampling frequency Fs is 8 times (N = 8) the sampling frequency fs. Between the digital filter 6 and the adder 11, there is connected the attenuator 16 which is of the same construction and operation as described with reference to FIGS. 4 and 6. The attenuator 16 attenuates the digital signal Vd by the dither level $L_{DTH}$ to the attenuated level $L_{ATT}$, thereby preventing an overflow. The digital signal Vh produced by the attenuator 16 is thus adjusted to the attenuated level $L_{ATT}$ and applied to the adder 11.

The sine-wave dither generator 17 applies a sinewave dither signal Vℓ to the adder 11. As shown in FIG. 8, the sine-wave dither signal Vℓ is given at a sampling frequency of 3.2 fs (= 0.4 Fs), for example. The dither frequency of 3.2 fs is outside of the audible frequency range, and is selected within the range of from $\frac{1}{2}$ • fs to $\frac{1}{2}$ • Nfs so that it is not adversely affected by the foldover noise. It is highly difficult to fabricate a low-pass filter having a sharp attenuation curve with a cutoff frequency of $\frac{1}{2}$ • fs. Practically, therefore, the dither frequency should preferably be selected to fall outside of the audible frequency range and as close to $\frac{1}{2}$ • Nfs as possible, with the result that the low-pass filter used may have a less steep attenuation curve. The sine-wave dither signal Vℓ of such dither frequency is added to the digital signal Vh from the attenuator 16 by the adder 11.

A sum signal Vi from the adder 11 is then fed to the D/A converter 12. The D/A converter 12. The D/A converter 12 converts the supplied digital signal Vi into an analog signal Vj. Since the digital signal Vi contains the sine-wave dither signal Vℓ, the level of the digital signal Vi fluctuates. As a consequence, conversion errors produced by the D/A converter 12 are not concentrated at a fixed point, but are dispersed, averaged, and reduced.

The analog signal Vj from the D/A converter 12 is applied to the low-pass filter 8 by which unwanted high frequency noise is removed from the analog signal Vj. The low-pass filter 8 produces a reproduced audio output signal Vf. The low-pass filter 8 has frequency characteristics as shown in FIG. 8. Since the sine-wave dither signal Vℓ has a frequency of 3.2 fs, the sine-wave dither signal Vℓ contained in the analog signal Vj from the D/A converter 12 is removed by the low-pass filter 8. Therefore, the sine-wave dither signal can easily be removed from the analog signal without subtraction. The D/A converter 15 and the subtractor 13 shown in FIG. 4 are not required by the arrangement shown in FIG. 7.

With the second embodiment, as described above, the digital signal Vi to which the sine-wave dither signal Vℓ of the suitably selected frequency is added can be converted into the analog signal Vj properly, and the dither signal Vℓ can subsequently be removed from the analog signal Vj only by the low-pass filter 8. Accordingly, the D/A converter device of the second embodiment is simple in circuit arrangement and advantageous with regard to characteristics and cost. Since the frequency of the sine-wave dither signal Vℓ is variable, it can be adjusted to match the attenuation curve of the low-pass filter 8, which is thus not required to have a very sharp attenuation curve. The low-pass filter 8 may thus be of a simple structure and a compact circuit arrangement.

Third Embodiment

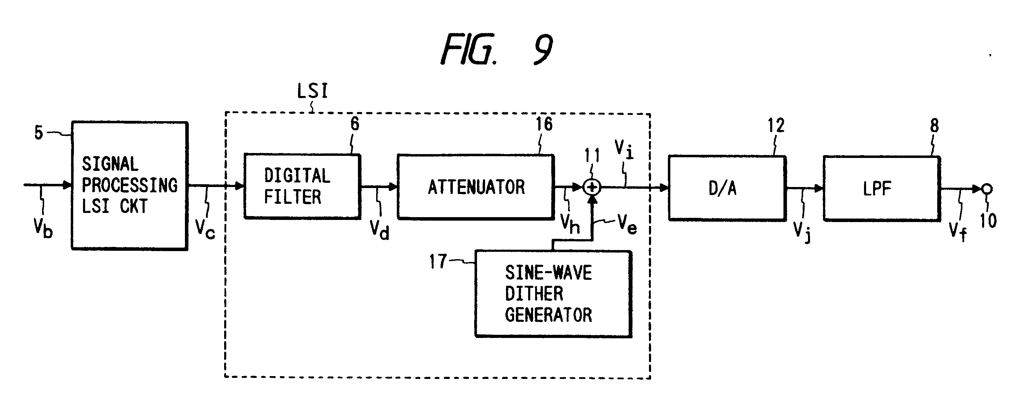

FIG. 9 shows a D/A converter device according to a third embodiment of the present invention.

The D/A converter device shown in FIG. 9 is in the form of a one-chip LSI circuit which includes the digital filter 6, the attenuator 16, the adder 11, and the sine-wave dither generator 17 which are shown in FIG. 7. The one-chip D/A converter device shown in FIG. 9 can be used in general-purpose applications since it can replace existing D/A converter devices. Inasmuch as the dither frequency of the sine-wave dither generator 17 is adjustable, the D/A converter device shown in FIG. 9 may be used as any of desired D/A converter device with increased freedom.

While the sine-wave dither signal $V\ell$ is used in the embodiments shown in FIGS. 7 and 9, a triangle-wave dither signal or a dither signal expressed by a periodic function may also be used.

The analog low-pass filter 8 is used as a means for removing the dither signal in the illustrated embodiments. However, any of various filters which can pass audible frequencies and attenuate dither signals may be used instead of the analog low-pass filter 8.

Although certain preferred embodiments have been shown and described, it should be understood that many changes and modifications may be made therein without departing from the scope of the appended claims.

## Claims

1. A digital-to-analog converter device including:
a digital filter (6) for removing digital noise from a digital signal which is sampled at a predetermined sampling frequency;
a dither generator (14, 17) for generating a dither signal;
an adder (11) for adding said dither signal to a digital signal from said digital filter (6):
and a D/A converter (12) for converting an output signal from said adder (11) into an analog signal, characterized by:
an attenuator (16) for attenuating the digital signal from said digital filter (8) to a level ($L_{ATT}$) which is lower than an overflow level ($L_{OVF}$) by the level ($L_{DTH}$) of said dither signal, and producing an attenuated output signal.

2. A digital-to-analog converter device according to claim 1, wherein said dither generator (14) generates a digital dither signal, further comprising a D/A converter (15) for converting said digital dither signal into an analog dither signal, and a subtractor (13) for subtracting said analog dither signal from the analog signal from said first-mentioned D/A converter (16).

3. A digital-to-analog converter device according to claim 1, wherein said dither generator (17) generates a dither signal ($V\ell$) expressed by a periodic function.

4. A digital-to-analog converter device according to claim 1, wherein said dither generator (17) generates a sine-wave dither signal ($V\ell$).

FIG. 1

FIG. 2

## *FIG. 3*

## *FIG. 4*

## FIG. 5

## FIG. 6

## FIG. 7

| SIGNAL PROCESSING LSI CKT (5) | → $V_c$ | DIGITAL FILTER (6) | → $V_d$ | ATTENUATOR (16) | → $V_h$ | ⊕ (11) | → $V_i$ | D/A (12) | → $V_j$ | LPF (8) | → $V_f$ |

$V_b$ → SIGNAL PROCESSING LSI CKT

$V_e$ ← SINE-WAVE DITHER GENERATOR (17)

## FIG. 8

SIGNAL LEVEL

MUSIC SIGNAL

DITHER SIGNAL

LPF CHARACTERISTICS

0   $f_s$   $2f_s$   $3f_s$   $4f_s$   $F_s = 8f_s$

SAMPLING FREQUENCY

EP 0 398 638 A2

FIG. 9